# EUROPÄISCHE PATENTSCHRIFT

(11) **EP 0 826 644 B1**
(45) Veröffentlichungstag und Bekanntmachung des Hinweises auf die Patenterteilung: **28.11.2001**
(21) Anmeldenummer: 97114503.2
(22) Anmeldetag: 21.08.1997
(51) Int. Cl.: C04B 35/478, C04B 35/497, C04B 35/622, C04B 35/624

(54) **Keramische und insbesondere piezoelektrische Mono- oder Multifilamentfasern und Verfahren zu deren Herstellung**
Ceramic and especially piezoelectric mono- or multifilament fibers and process for their production
Fibres céramiques et notamment piézoélectriques mono- ou multifilamentes et leur procédé de fabrication

(30) Priorität: 03.09.1996 DE 19635748
(43) Veröffentlichungstag der Anmeldung: 04.03.1998
(73) Patentinhaber: FRAUNHOFER-GESELLSCHAFT ZUR FÖRDERUNG DER ANGEWANDTEN FORSCHUNG E.V., 80636 München (DE)
(72) Erfinder: Scholz, Hermann, Dr., 97299 Zell a.M. (DE); Watzka, Winfried, 97082 Würzburg (DE); Vierhaus, Peter, 97082 Würzburg (DE)

(56) Entgegenhaltungen:
- EP-A- 0 260 868
- DE-C- 4 332 831
- US-A- 4 166 147
- S. YOSHIKAWA ET AL.: FERROELECTRICS, Bd. 154, 1994, Seiten 325-330, XP002074087

## Beschreibung

Die vorliegende Erfindung betrifft das Gebiet der Keramikfasern und insbesondere keramische Fasern, bevorzugt mit piezoelektrischen und/oder ferroelektrischen Eigenschaften, die sich in Bündeln mit Hilfe eines Sol-Gelverfahrens, Multifilamentschmelzspinnen und anschließender Pyrolyse herstellen lassen. Besonders interessant sind dabei Faserdurchmesser ab dem nicht mehr lungengängigen Bereich bis zu ca. 100 *µ*m, da die Verringerung des Durchmessers auf die genannten Bereiche einen "Quantensprung" in den piezoelektrischen Eigenschaften von mit den Fasern hergestellten Piezofaserverbundwerkstoffen erwarten läßt. Des weiteren bezieht sich die Erfindung insbesondere auf die Herstellung sehr langer, also kontinuierlich hergestellter Fasern mit ausgezeichneten Zugfestigkeiten, die sich erstmals durch das nachstehend beschriebene quasi-kontinuierliche Gesamtherstellungsverfahren mit den genannten mechanischen Eigenschaften erzeugen lassen.

In der Literatur und Patentliteratur wurde die Herstellung von polykristallinen, keramischen Strukturfasern seit Anfang der 70er Jahre verfolgt und beschrieben [A. Borer et al.: US Patent 3.760.049; 18. Sept. 1973; H.G. Sowman: US Patent 3.795.524; 5. März 1974; A.K. Dhingra, Phil. Trans. R. Soc. Lond. A 294, 411-417 (1980)].

Über ferroelektrische Funktionsfasern wie z.B. die Blei-Zirkonat-Titanat (PZT) Faser wurde erst Anfang der 90er Jahre berichtet [V.K. Seth: US Patent 4.921.328; 1. Mai 1990; K.C. Chen et al.: US Patent 5.072.035; 10. Dez. 1991; U. Selvaraj et al.: J. Mat. Res., Vol. 7, No. 4, 992 (1992). Das Interesse an dünnen PZT-Fasern geht zurück auf Untersuchungen von R.E. Newnham, der anhand von PZT-Stäben (400 bis 840µm im Durchmesser), die ausgerichtet in einer Polymermatrix eingebettet wurden, hervorragende piezoelektrische Eigenschaften für Ultraschallwandler und Sonare messen konnte [R.E. Newnham et al.: J. Am. Ceram. Soc. Vol. 64, No. 1, 5-9 (1981)]. In dieser Arbeit konnte gezeigt werden, daß der hydrostatische piezoelektrische Koeffizient mit abnehmenden Stäbchendurchmessern zunimmt. Jedoch ist die angewandte Herstellungsmethode der Extrusion, wie auch die heute für kommerziell erhältliche US-Wandler angewendete "dice and fill"-Methode auf die Herstellung von Stäbchen von ca. 100*µ*m im Durchmesser nach unten hin begrenzt.

S. Yoshikawa et al. beschreiben in Ferroelectrics, Vol. 154, 325-330 (1994) die Herstellung von Fasern im Multifilamentmodus mit reiner Perowskit-Struktur und einem Durchmesser von 30*µ*m. Die Fasern wurden aus einem erwärmten Sol heraus versponnen und auf einer Drehtrommel nach Verstrecken gesammelt. Nach Zerschneiden wurden 10cm lange Einzelfasern 10 Minuten lang auf 750 bis 1250°C erhitzt, wobei Fasern mit bis zu 55MPa Zugfestigkeiten erhalten wurden. Erreicht wurden Dichten bis zu 90%. Nachteil des Verfahrens sind die unkontrollierbaren rheologischen Eigenschaften des Sols, das nicht stabil ist und sich nur in einem sehr engen Temperatur- und Zeitfenster verspinnen läßt. Desweiteren müssen die von Yoshikawa et al. beschriebenen Fasern bei Temperaturen >1200°C verdichtet werden.

Auch die DE-PS 43 32 831 C1 der Fraunhofer-Gesellschaft beschreibt die Erzeugung von PZT-Keramikfasern mit Hilfe des Sol-Gel-Verfahrens durch Extrudieren, wobei man bis zu 600m lange Gelfasern erhalten kann. Diese Fasern wurden in aufgewickeltem Zustand innerhalb einer Stunde auf 660°C erhitzt, wobei man PZT-Keramikfasern mit einem Durchmesser von 10*µ*m erhielt. Die Gefügeausbildung und die mechanischen Eigenschaften der so erzeugten Fasern sind nicht befriedigend.

Aufgabe der vorliegenden Erfindung ist es, keramische Mono- oder Multifilamentfasern auf Basis von PbMO₃ bereitzustellen, die in gesintertem Zustand nicht nur ausgezeichnete ferroelektrische beziehungsweise piezoelektrische Eigenschaften, sondern auch ausgezeichnete mechanische Eigenschaften aufweisen. Aufgabe der vorliegenden Erfindung ist weiterhin die Bereitstellung eines Verfahrens, mit dem sich derartige verbesserte Fasern erzeugen lassen.

Die Aufgabe wird gelöst durch Bereitstellung von Fasern gemäß Anspruch 1 sowie durch die Bereitstellung von Verfahren gemäß den Ansprüchen 6, 9 und 12. Weitere Einzelheiten sind in den abhängigen Ansprüchen zu sehen.

Geeignet für die vorliegende Erfindung sind alle bleihaltigen Zusammensetzungen auf der Basis von PbMO₃, die zumindest teilweise in die Perowskit-Struktur überführt werden können, worin also das Element "M" die "B"-Position im Perowskit-Gitter besetzen kann. "Auf der Basis" soll dabei bedeuten, daß die Zusammensetzungen PbMO₃ ausschließlich oder in wesentlichen Anteilen enthalten. Abweichungen von der genauen Stöchiometrie sind möglich, beispielsweise durch einen Überschuß an Bleioxid im Sol (und dann in der Faser) oder durch Verlust von Bleioxid während des Sinterns. Die Zusammensetzung kann alternativ oder zusätzlich durch eine Vielzahl verschiedener Elemente dotiert sein, von denen einige nachstehend angegeben sind; sie kann solche Metalle bzw. deren Oxide auch ggf. in größeren Mengen enthalten, z.B. bis 5 oder 10 Gew.-%. Beim Element "M" in der "B"-Position kann es sich um ein einziges oder eine Kombination mehrerer Metalle handeln, wobei letztere ein und dieselbe oder aber unterschiedliche Wertigkeiten aufweisen können. Beispiele sind Zinn, Titan, Zirkonium, Hafnium, Lanthan, Vanadium, Niob, Magnesium, Tantal, Wolfram, Molybdän, Mangan, Antimon, Chrom, Nickel, Eisen, Zink, Scandium, Silicium, Germanium, Tellur, Aluminium und Kobalt. In besonders bevorzugten Systemen wird die "B"-Position von Zirkonium und Titan, ggf. zusätzlich von Lanthan, von Magnesium und von Niob, von Zink, Niob und Titan oder von Zirkon, Titan, Niob und Magnesium besetzt. Das System kann zusätzlich dotiert sein, beispielsweise mit einem oder mehreren der Elemente Niob, Lanthan, Magnesium, Scandium, Wolfram, Strontium, Zinn, Barium, Calcium, Wismuth, Antimon, Tantal, Fluor und Hafnium.

Die Gelfaservorstufen für die erfindungsgemäßen Fasern können beispielsweise wie in der deutschen Patentschrift DE 43 32 831 (Glaubitt et al.) über eine Sol-Gel-Route synthetisiert werden. Das Sol wird dabei aus Alkoholaten, ggf. zusammen mit weiteren Alkoholen, mit Carbonsäuren und Bleicarboxylaten umgesetzt, und die flüchtigen Anteile werden entfernt. Blei und ggf. ein weiteres Element kann unter Umständen in Form eines Oxids eingesetzt werden. Aus den genannten Ausgangsverbindungen entsteht eine Flüssigkeit, die man durch Abziehen flüchtiger Bestandteile in eine klare, hochviskose Flüssigkeit und ggf. in einen bei Raumtemperatur spröden, pulverisierbaren Feststoff mit organischen Anteilen überführen kann. Durch Erhitzen kann dieser Feststoff ggf. wieder flüssig gemacht werden.

In einer besonderen Ausführungsform wird das Spinnsol mit Perowskit-Keimen der gesuchten chemischen End-Zusammensetzung angereichert, beispielsweise in einer Menge von 0,1 bis 5 Masse-%.

Falls das Sol bei Raumtemperatur in festem Zustand vorliegt, wird es zum Verspinnen wieder verflüssigt. In einer bevorzugten Ausführungsform, dem System Blei-Zirkon-Titan-Sauerstoff, läßt sich das bei Raumtemperatur feste Sol bei 110 bis 150°C, bevorzugt bei 120 bis 130°C, schmelzen. Das flüssige Sol kann durch eine Düsenplatte mit Bohrungen extrudiert werden. Dabei kann es sich um die Extrusion von Monofilamenten oder Multifilamenten mit z.B. bis zu etwa 500 oder sogar 5000 Fasern und mehr handeln. Je nach gewünschtem Durchmesser der fertigen keramischen, ggf. piezoelektrischen und/oder ferroelektrischen Faser wird der Durchmesser der Bohrungen für die Düsenplatte gewählt, beispielsweise 0,1 bis 1,0 mm, bevorzugt 0,5mm. Das Extrudieren erfolgt vorzugsweise bei Temperaturen zwischen 100 und 180°C bei einem Druck von beispielsweise 0,11 MPa bis 10 MPa.

Die extrudierten Fasern werden über eine Trockenstrecke, beispielsweise von 0,5 bis 5 m und vorzugsweise von 1,0 bis 2,0 m Länge, geführt und sodann auf eine Rolle oder dergleichen aufgenommen und bei Bedarf verstreckt. Dabei läßt sich der Faserdurchmesser durch die Wickelgeschwindigkeit bzw. das Verstrecken einstellen. Beim Extrudieren durch Bohrungen mit den oben aufgeführten Durchmessern läßt sich der Faserdurchmesser der Gelfaser auf einen Bereich zwischen 5 und 150 *µ*m einstellen. Dafür sollte die Wickelgeschwindigkeit bei 1 bis 500 m/min, bevorzugt 20 bis 150 m/min liegen.

Die Separierung von Einzelfasern kann durch eine leistenförmige Anordnung der Spinndüsen erreicht und durch Aufbringen einer lösungsmitteldurchlässigen pyrolysierbaren Schlichte unterstützt werden.

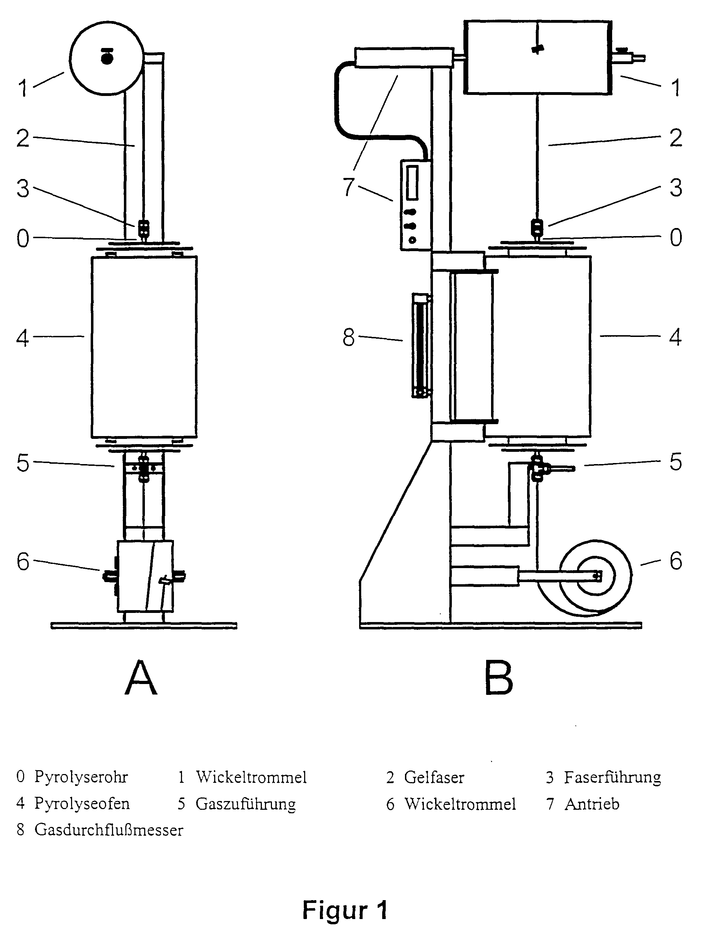

Nach dem Verspinnen werden die Fasern unter Berücksichtigung der Trocknungsschwindung einzeln bzw. im Bündel oder auch unter Zusammenführung mehrerer Bündel mit bis zu 2000 Einzelfasern abgewickelt und pyrolysiert. Sie können dabei in einer Ausführungsform kontinuierlich durch einen Pyrolyseofen durchgezogen werden. Fig. 1 stellt beispielhaft einen solchen Pyrolyseofen von der Seite (A) und von vorne (B) dar, durch den die Gelfaser oder das Gelfaserbündel 2 bevorzugt von unten nach oben von der unteren Wickeltrommel 6 auf die obere Wickeltrommel 1 geführt wird. Dabei durchläuft die Faser oder das Faserbündel ein Rohr oder eine Kapillare oder dergleichen, beispielsweise aus Al₂O₃ (in Fig. 1 mit 0 bezeichnet). Der Innendurchmesser wird nach der Anzahl der Filamente im Faserbündel gewählt und kann beispielsweise 5mm Innendurchmesser bei 8mm Außendurchmesser betragen, aber auch deutlich größer sein. Da die Fasern in Axialrichtung bei der Pyrolyse um ca. 40% schwinden, muß dies bei der Übersetzung der jeweiligen Wickeltrommeln 1 und 6 berücksichtigt werden. Die Fasertransportgeschwindigkeit hängt vom Material und von den gewählten Pyrolysetemperaturen ab und kann beispielsweise im Bereich von 5 mm bis 50 m/h liegen. Bevorzugt ist die in Figur 1 dargestellte Ausführungsform, in welcher mit dem Antrieb 7 die obere Wickeltrommel angetrieben wird, während die Wickeltrommel 6 passiv bewegt wird.

Mit Hilfe dieses Verfahrens lassen sich die gewünschten Festigkeitseigenschaften der Fasern erzielen, u.a. wahrscheinlich deshalb, weil die Fasern durch den Zug der Wickeltrommel 1 gereckt werden.

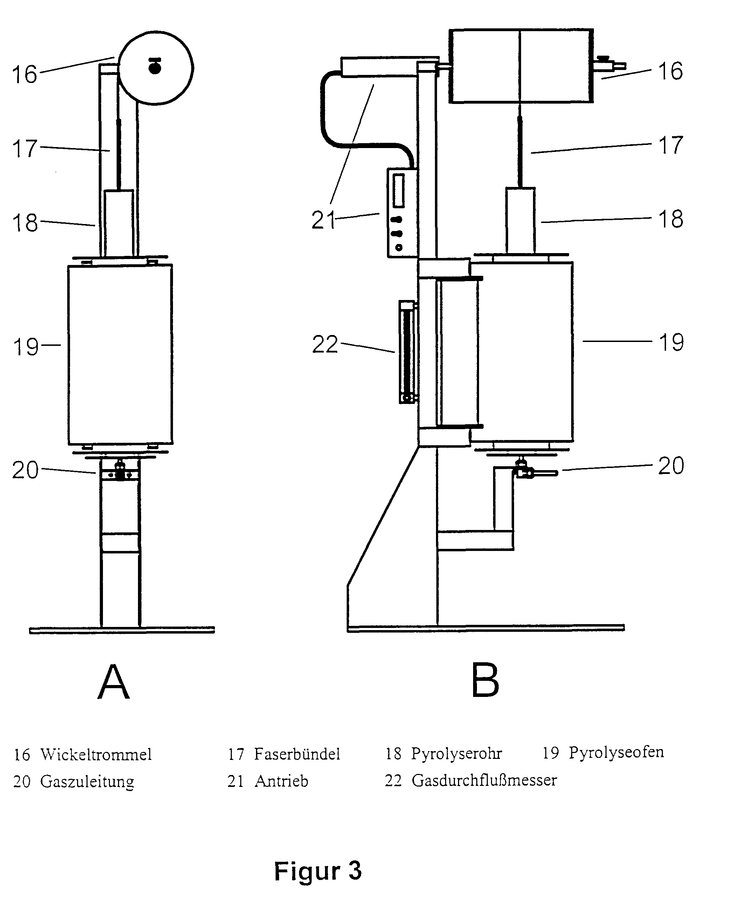

In einer alternativen Ausführungsform, die sich vor allem für das gleichzeitige Pyrolysieren einer Vielzahl weniger langer Fasern eignet, werden die Fasern diskontinuierlich pyrolysiert. Figur 3 zeigt beispielhaft einen entsprechenden Pyrolyseofen von der Seite (A) und von vorne (B). Dabei wird die Schwerkraft für das Erreichen der gewünschten mechanischen Eigenschaften genutzt, indem die Fasern, vorzugsweise in einem Bündel 17 (oder in mehreren solcher Bündel), bevorzugt von einer Rolle 16, entweder langsam in die Kammer 18 eines bereits aufgeheizten Pyrolyseofens 19 abgesenkt werden oder aber die Kammer des Pyrolyseofens, in die die Fasern von oben hineinhängen, mit einem entsprechenden Temperaturgradienten aufgeheizt wird. Auch hierbei stehen die Fasern unter Zug, was zur gewünschten Festigkeit zumindest beiträgt.

Die Fasern können für diese Verfahrensvariante an einer Aufhängung befestigt, beispielsweise eingespannt oder angeklebt werden.

In einer bevorzugten, ebenfalls in Figur 1 verdeutlichten Ausführungsvariante wird ein kontinuierlicher Gasstrom mit einer Geschwindigkeit von z.B. 1 bis 100 l/h (je nach Durchmesser des Pyrolyse-Rohres) von oben oder von unten durch das Pyrolyse-Rohr geleitet. In Figur 1 erkennt man eine Düse 5, durch die der Gasstrom in das Pyrolyse-Rohr eingeführt wird. Ganz besonders bevorzugt ist es dabei, Stickstoff oder ein Edelgas wie Argon mit einem Sauerstoffpartialdruck von 1x10⁻⁶ bis 0,05 MPa, ganz besonders zwischen 5 Pa und 21 kPa, einzusetzen. Wenn der Gasstrom im Gleichlauf mit den Fasern erfolgt, stützt er die mechanisch schwache Gelfaser, deren organische Bestandteile bei der Pyrolyse zunächst teilweise aufgeschmolzen werden, bevor sie thermisch zersetzt werden. Die Gefahr eines Abreißens der Faser wird dadurch stark verringert. Alternativ kann der Gasstrom auch in Gegenrichtung zum Faserlauf erfolgen. Dies hat die ebenfalls erwünschte Folge, daß der Abtransport der Pyrolysegase schneller vonstatten geht. Je nach Festigkeit der jeweiligen Gelfaser und der Volatilität der Pyrolysegase wird der Fachmann die zu bevorzugende Variante auswählen. Insbesondere bei Verwendung einer der vorgenannten Gasmischungen kann man sehr lange, rißfreie keramische Fasern erhalten, die nach der Pyrolyse entweder aufgewickelt werden oder direkt in einen nachgeschalteten Sinterofen überführt werden können.

Die Sinterung ist erforderlich, wenn die Keramikfasern optimale ferroelektrische und/oder piezoelektrische Eigenschaften aufweisen sollen.

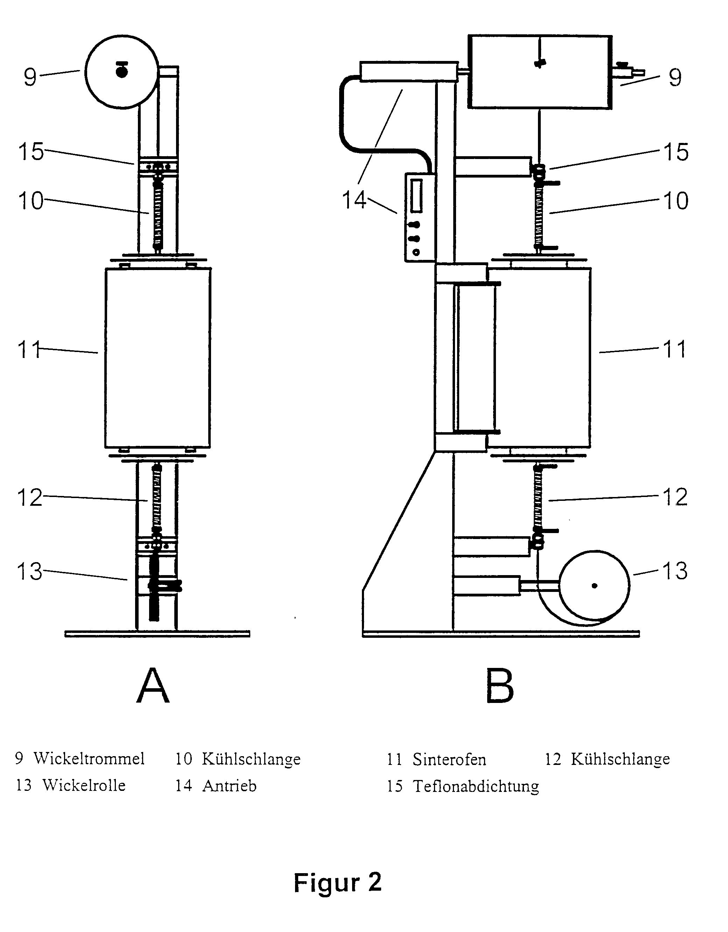

Das Sintern der Keramikfasern erfolgt vorzugsweise ebenfalls durch das kontinuierliche Führen der Einzelfaser oder der Multifilamente durch ein Rohr. Erfindungsgemäß wurde festgestellt, daß hierfür Temperaturen im Bereich von 650 bis 1400°C möglich, 800 bis 1000°C aber meist ausreichend bzw. bevorzugt sind, um ein dichtes Gefüge zu erhalten. Die Atmosphäre im Ofenraum selbst- ist bevorzugt stationär und weist einen PbO-Partialdruck auf. Das Rohr ist bevorzugt durch eine Verengung im Eintritts- und Austrittsbereich ein quasigeschlossener Bereich. Figur 2 zeigt schematisch einen solchen Sinterofen von der Seite (A) und von vorne (B). Die Verengung der Rohrenden kann durch durchbohrte Teflonstopfen 15 bewirkt werden, durch die das Faserbündel gezogen wird. Bevorzugt sind dem Ofenrohr Kühlfallen für die Kondensation von gasförmigem PbO vor- und nachgeschaltet, was in Figur 2 durch die Kühlschlangen 10 und 12 dargestellt ist. Diese können beispielsweise aus Kupfer bestehen. Dadurch wird das Austreten von PbO-Dampf in die Umgebung verhindert. Der PbO-Partialdruck kann beispielsweise durch Einmischen der entsprechenden Menge an gasförmigem PbO in die Ofenraumatmosphäre erzielt werden. Eine PbO-Verarmung der Atmosphäre durch Kondensation kann durch einen z. B. 0,1 bis 15 Mol-% betragenden PbO-Überschuß in der Faserzusammensetzung kompensiert werden. Zusätzlich oder alternativ kann eine PbO-haltige Beschichtung auf die Innenseite der Ofenkammer appliziert werden. Bei ausreichender Zufuhr von PbO aus der Faser bzw. der Ofenkammer-Innenschicht kann sich ggf. ein ausreichendes Gleichgewicht des PbO-Partialdrucks in der Sinteratmosphäre ausbilden, so daß auf die Zufuhr von gasförmigem PbO in den Ofenraum verzichtet werden kann.

Die Fasertransportgeschwindigkeit ist allerdings bei gekoppelter Pyrolyse-Sinter-Anordnung (kontinuierliches Pyrolysieren wie in Figur 1 dargestellt) durch die Pyrolyse-Geschwindigkeit festgelegt.

Die nach der Sinterung resultierenden Faserdurchmesser betragen für durch Bohrungen von 0,1 bis 1,0 mm extrudierte Gelfasern 3 bis 100 *µ*m, bevorzugt 5 bis 30 *µ*m, wobei, wie bereits vorstehend erwähnt, durch Verstreckung eine Feineinstellung erzielt werden kann.

Die Gefügeentwicklung (Größe, Morphologie) der Fasern kann durch die Veränderungen des PbO-Gehaltes und/oder Dotierungen mit Elementen wie La, Nb, Mg, Sn, etc., ferner der Sintertemperatur und/oder der Sinterdauer verändert werden. Die Korngrößen liegen meist im Bereich von 0,1 *µ*m bis 1000 *µ*m, bevorzugt im Bereich von 0,3 bis 10 *µ*m. Nach 5-stündiger Sinterung bei 850°C in PbO-haltiger Luftatmosphäre beträgt die mittlere Korngröße z.B. 1,8 *µ*m.

Sowohl der Pyrolyse- als auch der Sinterofen können induktiv oder widerstands- oder mikrowellenbeheizt sein. Die Länge der Brennkammer ist variabel und kann den Umständen entsprechend z.B. 20 cm lang oder auch 10 m lang sein.

Nach Pyrolyse und Sinterung erhält man mit dem erfindungsgemäßen Verfahren überraschend hohe Zugfestigkeiten im Bereich von über 100 MPa bis ungefähr 150 MPa, die weit über denen der diskontinuierlich liegend pyrolysierten und gesinterten Fasern liegen.

In einem sich an die Sinterung anschließenden Beschichtungsschritt kann durch kontinuierliche Benetzung des Faserbündels oder der separierten Einzelfasern eine thermoplastische oder duroplastische Polymerschicht mit einer Dicke von 1 bis 200% des Faserdurchmessers auf die Faseroberfläche aufgebracht werden.

Wird das Spinnsol mit Perowskit-Keimen angereichert, die in einem gestreckten Habitus entlang kristallographisch bevorzugter Achsen vorliegen, welche sich durch einen hohen elektromechanischen Kopplungsfaktor auszeichnen, werden diese durch den Spinnprozeß entlang der Gelfaserachse ausgerichtet. Durch heterogene Keimbildung und/oder Temperaturgradienten während der kontinuierlichen Pyrolyse und Sinterung können Kristallwachstum und Orientierung der ursprünglich polykristallin vorliegenden Kristallite durch epitaktisches Aufwachsen auf den eingebrachten Keimen zu langgestreckten, faserförmigen, einkristallinen Bereichen mit der gewünschten kristallographischen Orientierung führen.

Die Erfindung wird nachfolgend anhand mehrerer **Ausführungsbeispiele** erläutert und ergänzt.

### Beispiel 1:

Ein hydrolysiertes und kondensiertes Sol der Zusammensetzung 1/3 Pb(OAc)₂x2/3 PbOxZrO_{0,53}Ti_{0,47}O_{0,6}(OH)_{1,2}(OOCEt)_{1,6} wird bei 125°C und einem Druck von 1,5 MPa durch eine Fünfloch-Düsenplatte mit jeweils 500 *µ*m Düsendurchmesser extrudiert. Nach einer Trockenstrecke von 1,8 m werden die Fasern auf einer rotierenden Trommel mit einer Geschwindigkeit von 50 m/min aufgenommen und auf einen Faserdurchmesser von ca. 50 *µ*m verstreckt. Die frisch versponnenen Gelfasern werden bei Raumtemperatur und ca. 50%iger Luftfeuchte 24 Stunden auf der Aufnehmerrolle bei reduziertem Rollenradius (um Schwindung der Fasern zu ermöglichen) getrocknet. Im folgenden wird die Faserrolle unter dem Pyrolyseofen eingespannt, der Faserbündelanfang durch den Ofen gefädelt und an der oberen Führungsrolle befestigt. Nach Aufheizen des Ofens auf 600°C mit 1,5 K/min wird das Gelfaserbündel mit einer Geschwindigkeit der oberen Rolle von 15 mm/h durch den Ofen gezogen, wobei die untere Rolle unter Berücksichtigung der Faserlängenschwindung von 40% eine Geschwindigkeit von ca. 25 mm/h hat. Der Fasertransport wird durch einen Stickstoffstrom von 9 l/h unterstützt. Der Sauerstoffgehalt im Stickstoff-Transportgas beträgt 450 vpm. Die sich der Pyrolyse anschließende Sinterung erfolgt bei einer Temperatur von 900°C und einer konstanten Fasertransportgeschwindigkeit von 40 mm/h. Die Einzelfasern des Bündels zeigen nach der Sinterung einen Durchmesser von ca. 30 *µ*m. Die Gefügedichte beträgt größer 98%, die Korngrößen liegen bei 2 bis 4 *µ*m. Chemische Analyse, röntgenographische und energiedispersive Spektroskopie verifizieren die gewünschte Stöchiometrie Pb(Zr_{0,53}Ti_{0,47})O₃.

### Beispiel 2:

Ein Sol der Zusammensetzung wie in Beispiel 1 mit Zusatz von 0,012 mol Niobethylat und 0,012 mol gelöstem MgO wird bei einer Temperatur von 130°C und einem Druck von 1,0 MPa im 15 Filamentmodus versponnen und nach einer Trockenstrecke von 1,2 m mit 120 m/min auf Durchmesser von ca. 15 *µ*m verstreckt und aufgewickelt. Unter den Pyrolysebedingungen von Beispiel 1 führt die Sinterung bei 950°C mit einer Fasertransportgeschwindigkeit von 55 mm/h zu einem Einzelfaserdurchmesser von ca. 9 *µ*m mit nahezu dichtem (> 95%) Gefüge der Zusammensetzung Pb(Zr_{0,53}Ti_{0,446}Nb_{0,012}Mg_{0,012})O₃. Die aus dem Sinterofen austretenden Fasern werden durch einen Kamm separiert, der mit einem kontinuierlich gemischten Epoxidharz/Härtergemisch benetzt wird. Dadurch werden die Einzelfasern mit einer Epoxidharzschicht versehen. In einem anschließenden Schritt werden die Faserbeschichtungen thermisch bei 130°C gehärtet, bevor die Fasern wieder zu einem Bündel zusammengeführt werden.

Keramische Endlosfasern in Bündeln mit bis zu 500 und mehr Monofilamenten aus Sol-Gel abgeleiteten Gelfasermultifilamenten lassen sich also durch kontinuierliche Pyrolyse herstellen und durch Sintern in die gewünschte Kristallstruktur mit den gewünschten elektrischen Eigenschaften überführen. Bevorzugt besitzen sie Faserdurchmesser zwischen 3 und 100 *µ*m und ein nach dem Sintern polykristallines Gefüge mit Korngrößen zwischen 0,1 und 1000 *µ*m, die durch Keimbildner und kontrolliertes Kristallwachstum in bevorzugten kristallographischen Richtungen orientiert werden können. Das Verfahren zur Umwandlung der Gelfasern in keramische Fasern umfaßt einen kontinuierlichen Pyrolyseschritt der Faser bei Temperaturen bis etwa 700°C in einem Durchlaufofen, in dem bevorzugt ein N₂-Gasstrom mit definiertem Sauerstoffpartialdruck, ganz besonders bevorzugt von 5x10⁻⁶ bis 0,021 MPa, und einem Volumenstrom von bevorzugt 1 bis 100 l/h in der oder gegen die Faserrichtung geführt wird. In einem zweiten Schritt der Temperaturbehandlung, der in einem in Serie über bzw. unter dem Pyrolyseofen angeordneten Durchlaufsinterofen stattfinden kann, kann die Faser unter PbO-Partialdruckkontrolle in sauerstoffhaltigen Atmosphären, vorzugsweise in Luft, bei Temperaturen bis 1400°C, bevorzugt bis 1000°C gesintert werden.

## Patentansprüche

1. Keramische Mono- oder Multifilamentfasern auf der Basis von PbMO₃,
worin M ein metallisches Element oder eine anteilige Kombination verschiedener metallischer Elemente bedeutet, das/die die "B"-Position im Perowskit-Gitter besetzen kann/können,
mit einer Zugfestigkeit von mindestens 100 MPa.

2. Keramische Fasern nach Anspruch 1, zusammengesetzt aus den Systemen Pb-Zr-Ti-O, Pb-La-Zr-Sn-Ti-O, Pb-Mg-Nb-O, Pb-Zr-Ti-Nb-Mg-O oder Pb-Zn-Nb-Ti-O, wobei die genannten Systeme weiterhin mit einem oder mehreren der Elemente La,Nb,Mg,Sc,W,Sr,Sn,Ba,Ca,Bi,Sb,Ta,F oder Hf dotiert sein können.

3. Keramische Fasern nach einem der voranstehenden Ansprüche, worin der Faserdurchmesser 5 bis 30 Mikrometer beträgt.

4. Keramische Fasern nach einem der voranstehenden Ansprüche, **dadurch gekennzeichnet, daß** sie ein polykristallines Perowskit-Gefüge mit Korngrößen zwischen 0,3 und 10 Mikrometer besitzen, wobei ggf. langgestreckte, einkristalline Bereiche vorhanden sind.

5. Keramische Fasern nach einem der voranstehenden Ansprüche, **dadurch gekennzeichnet daß** die Fasern piezoelektrische und/oder ferroelektrische Eigenschaften aufweisen.

6. Verfahren zum Herstellen von keramischen Mono- oder Multifilamentfasern auf Basis von PbMO₃, worin M ein metallisches Element oder eine anteilige Kombination verschiedener metallischer Elemente bedeutet, das/die die "B"-Position im Perowskit-Gitter besetzen kann/können, umfassend die Schritte:
- Extrudieren eines Sols entsprechender organischer Metallverbindungen, gegebenenfalls in Kombination mit Metalloxiden, durch eine oder mehrere Spinndüsen,
- Trocknen und Aufwickeln der entstandenen Fasern,
- kontinuierliches Führen einer Faser oder eines Faserbündels durch die langgestreckte Kammer eines Pyrolyseofens, wobei die Faser oder das Faserbündel einer Temperatur ausgesetzt wird, die zum Entfernen des organischen Materials ausreicht.

7. Verfahren nach Anspruch 6, worin die Pyrolyse mit einer Temperatur von bis zu etwa 700°C erfolgt und die Durchlaufgeschwindigkeit der Mono- oder Multifilamentfasern im Bereich von 5mm bis 50m/h liegt.

8. Verfahren nach einem der Ansprüche 6 oder 7, worin in Gleichrichtung mit oder in Gegenrichtung zu dem Faserlauf Gas durch das erhitzte Rohr geleitet wird, wobei ggf. der Gasvolumenstrom 1 bis 100 l/h beträgt und/oder das Gas aus Stickstoff mit einem Sauerstoffpartialdruck im Bereich von etwa 1 x 10⁻⁶ bis 0,05 MPa besteht.

9. Verfahren zum Herstellen von keramischen Mono- oder Multifilamentfasern auf Basis von PbMO₃, worin M ein metallisches Element oder eine anteilige Kombination verschiedener metallischer Elemente bedeutet, das/die die "B"-Position im Perowskit-Gitter besetzen kann/können, umfassend die Schritte:
- Extrudieren eines Sols entsprechender organischer Metallverbindungen, ggf. in Kombination mit Metalloxiden, durch eine Vielzahl von Spinndüsen,
- Trocknen und ggf. Aufwickeln der entstandenen Fasern,
- Erwärmen eines oder mehrerer Faserbündel(s) in der langgestreckten Kammer eines Pyrolyseofens durch langsames Absenken des oder der an einer Befestigung hängenden Faserbündel(s) in die Kammer oder durch entsprechendes Aufheizen eines oder mehrerer stationär von oben in die Kammer hineinhängenden Faserbündel(s), wobei das oder die Faserbündel einer Temperatur ausgesetzt wird/werden, die zum Entfernen des organischen Materials ausreicht.

10. Verfahren nach Anspruch 9, worin die Pyrolyse mit einer Temperatur von bis zu etwa 700°C erfolgt und die Absenkgeschwindigkeit der Fasern im Bereich von 5 mm bis 50 m/h liegt oder die Aufheizrate des Faserbündels 5 K/h bis 100 K/min beträgt.

11. Verfahren nach Anspruch 9 oder 10, worin Gas durch die Kammer des Pyrolyseofens geleitet wird, und ggf. der Gasvolumenstrom 1 bis 100l/h beträgt und/oder das Gas aus Stickstoff mit einem Sauerstoffpartialdruck im Bereich von etwa 1 x 10⁻⁶ bis 0,05 MPa besteht.

12. Verfahren zum Herstellen von keramischen piezoelektrischen und/oder ferroelektrischen Mono- oder Multifilamentfasern auf Basis von PbMO₃, worin M ein metallisches Element oder eine anteilige Kombination verschiedener metallischer Elemente bedeutet, das/die die "B"-Position im Perowskit--Gitter besetzen kann/können,
worin keramische Mono- oder Multifilamentfasern, hergestellt nach einem der Ansprüche 6 bis 11, in sauerstoffhaltiger Atmosphäre in Gegenwart eines PbO-Partialdrucks gesintert werden.

13. Verfahren nach Anspruch 12, wobei die keramischen Mono- oder Multifilamentfasern kontinuierlich durch die langgestreckte Kammer eines auf etwa 800 bis 1000°C erhitzten Sinterofens geführt werden und/oder daß die sauerstoffhaltige Sinteratmosphäre mit PbO-Partialdrücken von 10⁻³⁰ bis 10⁵ Pa angereichert ist.

14. Verfahren nach einem der Ansprüche 12 oder 13, **dadurch gekennzeichnet,**
**daß** die Anreicherung der sauerstoffhaltigen Sinteratmosphäre mit PbO durch eine Pb-haltige Beschichtung der Ofenkammerinnenfläche oder durch die Abgabe von überstöchiometrischem PbO aus der Faser erzielt wird.

15. Verfahren zum Herstellen von keramischen und gegebenenfalls piezoelektrischen Mono- oder Multifilamentfasern nach einem der Ansprüche 6 bis 14, **dadurch gekennzeichnet,**
**daß** dem verflüssigten Sol 0,1 bis 5 Masse-% Perowskit-Keime der entsprechenden Zusammensetzung PbMO₃ beigefügt sind, die in einem gestreckten Habitus entlang kristallographisch bevorzugter Achsen vorliegen, welche sich durch einen hohen elektromechanischen Kopplungsfaktor auszeichnen.

## Claims

1. Ceramic mono- or multifilament fibres based on PbMO₃,
wherein M means a metallic element or a proportional combination of various metallic elements which element(s) can occupy the "B" position in the perovskite lattice, having a tensile strength of at least 100 MPa.

2. Ceramic fibres according to claim 1, composed from the Pb-Zr-Ti-O, Pb-La-Zr-Sn-Ti-O, Pb-Mg-Nb-O, Pb-Zr-Ti-Nb-Mg-O or Pb-Zn-Nb-Ti-O systems, the above-mentioned systems furthermore being able to be doped with one or more of the elements La, Nb, Mg, Sc, W, Sr, Sn, Ba, Ca, Bi, Sb, Ta, F or Hf.

3. Ceramic fibres according to one of the preceding claims, wherein the fibre diameter is 5 to 30 micrometres.

4. Ceramic fibres according to one of the preceding claims, **characterised in that** they have a polycrystalline perovskite structure with particle sizes between 0.3 and 10 micrometres, possibly extended monocrystalline regions being present.

5. Ceramic fibres according to one of the preceding claims, **characterised in that** the fibres have piezoelectric and/or ferroelectric properties.

6. Method for producing ceramic mono- or multifilament fibres based on PbMO₃, wherein M means a metallic element or a proportional combination of various metallic elements, which element(s) can occupy the "B" position in the perovskite lattice, comprising the steps:
• extrusion of a sol of corresponding organic metal compounds, possibly in combination with metallic oxides, through one or more spinning jets,
• drying and winding-up of the resultant fibres,
• continuous guiding of a fibre or a fibre bundle through the extended chamber of a pyrolysis furnace, the fibre or the fibre bundle being subjected to a temperature which is adequate for the removal of the organic material.

7. Method according to claim 6, wherein the pyrolysis is effected at a temperature of up to approximately 700 °C and the flow rate of the mono- or multfilament fibres is in the range of 5 mm to 50 m/h.

8. Method according to one of the claims 6 or 7, wherein gas is conducted through the heated pipe in the same direction or in a counter-direction to the course of the fibre, possibly the gas volume flow being 1 to 100 l/h and/or the gas comprising nitrogen with an oxygen partial pressure in the range of approximately 1 x 10⁻⁶ to 0.05 MPa.

9. Method for producing ceramic mono- or multifilament fibres based on PbMO₃, wherein M means a metallic element or a proportional combination of various metallic elements, which element(s) can occupy the "B" position in the perovskite lattice, comprising the steps:
• extrusion of a sol of corresponding organic metal compounds, possibly in combination with metallic oxides, through a multitude of spinning jets,
• drying and possibly winding-up of the resultant fibres,
• heating of one or more fibre bundle(s) in the extended chamber of a pyrolysis furnace by slowly lowering the fibre bundle(s), which are suspended on an attachment, into the chamber or by corresponding heating of one or more fibre bundle(s) which are suspended in a stationary manner from above in the chamber, the fibre bundle(s) being subjected to a temperature which is adequate for the removal of the organic material.

10. Method according to claim 9, wherein the pyrolysis is effected at a temperature of up to approximately 700 °C and the withdrawal rate of the fibres is in the range of 5 mm to 50 m/h or the heating rate of the fibre bundle is 5 K/h to 100 K/min.

11. Method according to claim 9 or 10, wherein gas is conducted through the chamber of the pyrolysis furnace, and possibly the gas volume flow is 1 to 100 l/h and/or the gas comprises nitrogen with an oxygen partial pressure in the range of approximately 1 x 10⁻⁶ to 0.05 MPa.

12. Method for producing ceramic piezoelectric and/or ferroelectric mono- or multifilament fibres based on PbMO₃, wherein M means a metallic element or a proportional combination of various metallic elements, which element(s) can occupy the "B" position in the perovskite lattice,
wherein ceramic mono- or multifilament fibres, produced according to one of the claims 6 to 11, are sintered in an oxygen-containing atmosphere in the presence of a PbO partial pressure.

13. Method according to claim 12, the ceramic mono- or multifilament fibres being guided continuously through the extended chamber of a sintering furnace which is heated to a temperature of approximately 800 to 1000 °C and/or that the oxygen-containing sintering atmosphere is enriched with PbO partial pressures of 10⁻³⁰ to 10⁵ Pa.

14. Method according to one of the claims 12 or 13,
**characterised in that**
the enriching of the oxygen-containing sintering atmosphere with PbO is achieved by means of a PbO-containing coating of the furnace chamber internal surface or by means of the release of hyperstoichiometric PbO from the fibre.

15. Method for producing ceramic and possibly piezoelectric mono- or multifilament fibres according to one of the claims 6 to 14, **characterised in that**
0.1 to 5 % by mass of perovskite nuclei of the corresponding composition PbMO₃ are added to the liquefied sol, which nuclei occur in an extended physical appearance along crystallographically preferred axes which are distinguished by a high electromechanical coupling factor.

## Revendications

1. Fibres céramiques de mono- ou multifilaments à base de PbMO₃, dans lesquelles M représente un élément métallique ou une combinaison partagée de divers éléments métalliques, et qui peut(peuvent) posséder la position "B" dans la grille de perowskite,
avec une résistance à la traction d'au moins 100 MPa.

2. Fibres céramiques selon la revendication 1, composées des systèmes Pb-Zr-Ti-O, Pb-La-Zr-Sn-Ti-O, Pb-Mg-Nb-O, Pb-Zr-Ti-Nb-Mg-O ou Pb-Zn-Nb-Ti-O, où les systèmes mentionnées peuvent en outre être additionnés d'un ou plusieurs des éléments La, Nb, Mg, Sc, W, Sr, Sn, Ba, Ca, Bi, Sb, Ta, F ou Hf.

3. Fibres céramiques selon l'une des revendications précédentes, dont le diamètre des fibres s'élève à 5 à 30 µm.

4. Fibres céramiques selon l'une des revendications précédentes,
**caractérisées en ce qu'**
elle possèdent une structure polycristalline de perowskite avec des granulométries comprises entre 0,3 et 10 µm, avec le cas échéant présence de domaines monocristallins étirés longitudinalement.

5. Fibres céramiques selon l'une des revendications précédentes,
**caractérisées en ce que**
les fibres présentent des propriétés piézoélectriques et/ou ferroélectriques.

6. Procédé de fabrication de fibres céramiques mono- ou multifilaments à base de PbMO₃, dans lesquelles M représente un élément métallique ou une combinaison partagée de divers éléments métalliques, qui peuvent posséder la position "B" dans une ossature de perowskite, comprenant les étapes suivantes :
- extrusion d'un sol de composés organométalliques correspondant, le cas échéant en combinaison avec des oxydes métalliques, à travers une ou plusieurs buses de filage,
- séchage et mise en bobines des fibres apparues,
- conduite continue d'une fibres ou d'un faisceau de fibres à travers la chambre étirée longitudinalement d'un four à pyrolyse, les fibres ou faisceaux de fibres étant soumis à une température qui suffit pour enlever le matériau organique.

7. Procédé selon la revendication 6,
selon lequel la pyrolyse s'effectue à une température allant jusqu'à environ 700°C et la vitesse de parcours des fibres mono- ou multifilaments se situe dans un intervalle de 50 mm à 50 m/heure.

8. Procédé selon l'une des revendications 6 ou 7,
selon lequel en direction identique ou à contre-courant du défilement des fils, du gaz est conduit à travers le tube chauffé, où le cas échéant le courant volumique de gaz s'élève à 1 à 100 l/heure et/ou le gaz se compose d'azote avec une pression partielle d'oxygène allant d'environ 1 x 10⁻⁶ à 0,05 MPa.

9. Procédé de production de fibres céramiques mono- ou multifilaments à base de PbMO₃, dans lesquelles M est un élément métallique ou une combinaison partagée de divers éléments métalliques, qui peuvent posséder la position "B" dans la grille de perowskite, comprenant les étapes suivantes :
- extrusion d'un sol de composés organométalliques correspondants, le cas échéant en combinaison avec des oxydes métalliques, par un grand nombre de buses de filage,
- séchage et le cas échéant mise en bobines des fibres apparues,
- chauffage d'un ou plusieurs faisceaux de fibres dans la chambre étirée longitudinalement d'un four à pyrolyse par lent abaissement du ou des faisceaux de fibres pendant à une suspension dans la chambre, ou par chauffage correspondant d'un ou plusieurs faisceaux de fibres suspendus de façon stationnaire par le haut dans la chambre, où le ou les faisceaux de fibres est ou sont exposés à une température qui suffit pour éliminer le matériau organique.

10. Procédé selon la revendication 9,
selon lequel la pyrolyse s'effectue à une température allant jusqu'à environ 700°C et la vitesse d'abaissement des fibres est située dans un intervalle de 5 mm à 50 m/heure ou la vitesse de chauffage du faisceau de fibres est comprise entre 5 K/h à 100 K/minute.

11. Procédé selon la revendication 9 ou 10,
selon lequel on conduit du gaz à travers la chambre du four à pyrolyse, et le cas échéant le courant volumique de gaz s'élève à 1 à 100 l/heure, et/ou le gaz se compose d'azote avec une pression partielle d'oxygène allant d'environ 1 x 10⁻⁶ à 0,05 MPa.

12. Procédé de production de fibres céramiques mono- ou multifilaments piézoélectriques ou/ou ferroélectriques à base de PbMO₃, dans lesquelles M représente un élément métallique ou une combinaison partagée de divers éléments métalliques, qui peuvent posséder la position "B" dans la grille de perowskite,
selon lequel les fibres mono- ou multifilaments produites selon l'une des revendications 6 à 11, sont frittées dans une atmosphère contenant de l'oxygène en présence d'une pression partielle de PbO.

13. Procédé selon la revendication 12,
selon lequel on conduit les fibres céramiques mono- ou multifilaments de façon continue à travers la chambre étirée longitudinalement d'un four de frittage chauffé à environ 800 à 1000°C et/ou dans lequel l'atmosphère de frittage contenant de l'oxygène est enrichie avec des pressions partielles de PbO de 10⁻³⁰ à 10⁵ Pa.

14. Procédé selon l'une des revendications 12 ou 13,
**caractérisé en ce que**
l'enrichissement de l'atmosphère de frittage contenant de l'oxygène avec PbO est produit par un revêtement, contenant du plomb, de la surface interne de la chambre du four, ou par la libération de PbO à un niveau suprastoechiométrique à partir des fibres.

15. Procédé de production de fibres mono- ou multifilements céramiques et le cas échéant piézoélectriques selon l'une des revendications 6 à 14,
**caractérisé en ce qu'**
on ajoute au sol liquéfié de 0,1 à 5 % massique de germes de perowskite de composition en PbMO₃ correspondante, qui se présentent dans un faciès cristallin étiré le long d'axes cristallographiquement préférés, qui se caractérisent par un facteur de couplage électromécanique élevé.
